# EUROPÄISCHE PATENTSCHRIFT

(11) **EP 0 537 505 B1**
(45) Veröffentlichungstag und Bekanntmachung des Hinweises auf die Patenterteilung: **04.06.1997**
(21) Anmeldenummer: 92116103.0
(22) Anmeldetag: 21.09.1992
(51) Int. Cl.: G01R 31/305

(54) **Verfahren zur Erkennung von Testfehlern beim Test von Mikroverdrahtungen**
Method for detecting testing faults whilst testing micro-interconnections
Méthode pour détecter des fautes de test en testant des micro-fileries

(30) Priorität: 16.10.1991 DE 4134243
(43) Veröffentlichungstag der Anmeldung: 21.04.1993
(73) Patentinhaber: EBETECH Electron-Beam Technology Vertriebs GmbH, 85551 Heimstetten (DE)
(72) Erfinder: Brunner, Matthias, Dr., W-8011 Kirchheim (DE); Schmid, Ralf, W-8000 München 2 (DE)
(74) Vertreter: Tetzner, Volkmar, Dr.-Ing. Dr. jur.

(56) Entgegenhaltungen:
- EP-A- 0 189 777
- EP-A- 0 389 397
- DE-A- 1 946 931
- DE-A- 2 814 049

## Beschreibung

Die vorliegende Erfindung betrifft Verfahren nach den Oberbegriffen 1, 2 und 3.

Verfahren der gattungsgemäßen Art sind aus der europäischen Anmeldeschrift EP-A-0 189 777 bekannt. Dabei handelt es sich um Verfahren, die beispielsweise aufgrund von vorhandenen Mikrofeldern oder Oberflächenverunreinigungen auf der zu testenden Leiterplatte falsche Testergebnisse liefern können.

Der Erfindung liegt nun die Aufgabe zugrunde, verbesserte Verfahren anzugeben, die mit Hilfe von zusätzlichen Zwischen-bzw. Nachtests eine Unterscheidung zwischen Testfehlern und echten Fehlern (Unterbrechungen, Kurzschlüsse) der Leiterplatte ermöglichen. Diese Aufgabe wird durch die in den kennzeichnenden Teilen der Patentansprüche 1, 2 und 3 angegebenen Merkmale gelöst.

Der mit der Erfindung erzielbare Vorteil liegt insbesondere darin, daß sich bei den erfindungsgemäßen Verfahren durch relativ wenig zusätzliche Tests (Zwischentest, Nachtest) zuverlässigere Testergebnisse erzielen lassen als bei den oben genannten bekannten Verfahren.

Die Patentansprüche 4 bis 6 sind auf bevorzugte Weiterbildungen eines Verfahrens gerichtet.

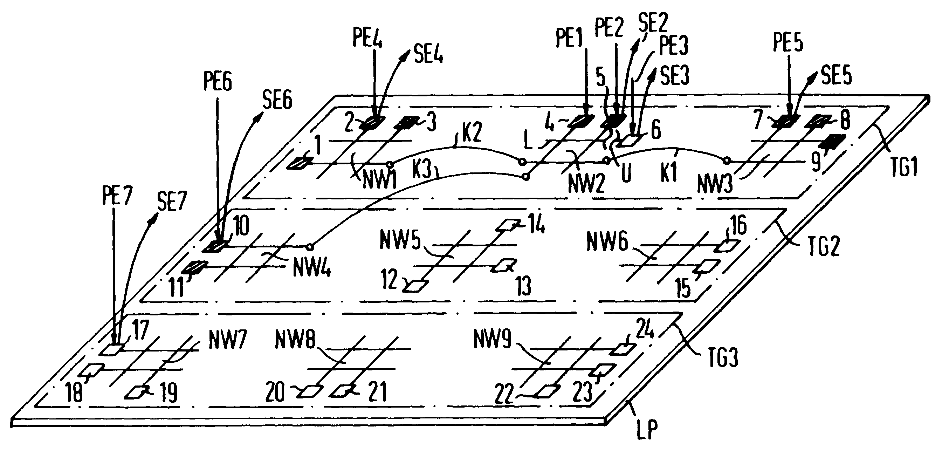

Die Erfindung wird nachfolgend anhand der Zeichnung erläutert.

Zur Darstellung der erfindungsgemäßen Verfahren ist in der Zeichnung eine perspektivische Darstellung einer Leiterplatte LP gezeigt, auf deren Oberfläche sich voneinander isolierte Netzwerke NW1 ... NW9 befinden, wobei die Netzwerke NW1 ... NW3 zu einer Testgruppe TG1, die Netzwerke NW4 ... NW6 zu einer Testgruppe TG2 und die Netzwerke NW7 ... NW9 zu einer Testgruppe TG3 zusammengefaßt sind. Jedes der Netzwerke NW1 ... NW9 besitzt eine Mehrzahl von Kontaktpunkten 1 ... 24, wobei das Netzwerk NW1 die Kontaktpunkte 1, 2 und 3, das Netzwerk NW2 die Kontaktpunkte 4, 5 und 6, das Netzwerk NW3 die Kontaktpunkte 7, 8 und 9, das Netzwerk NW4 die Kontaktpunkte 10 und 11, das Netzwerk NW5 die Kontaktpunkte 12, 13 und 14, das Netzwerk NW6 die Kontaktpunkte 15 und 16, das Netzwerk NW7 die Kontaktpunkte 17, 18 und 19, das Netzwerk NW8 die Kontaktpunkte 20 und 21 und das Netzwerk NW9 die Kontaktpunkte 22, 23 und 24 besitzt. Die Netzwerke NW1 ... NW9 sind symbolisch durch zwei sich rechtwinklig kreuzende parallelen Paare angedeutet und im Netzwerk NW2 ist eine Leitung des Netzwerkes mit L bezeichnet. Die Leitung L weist eine Unterbrechung U auf, die den Kontaktpunkt 6 vom übrigen Netzwerk NW2 abtrennt. Das Netzwerk NW2 ist über einen Kurzschluß K1 mit dem Netzwerk NW3, über einen Kurschluß K2 mit dem Netzwerk NW1 und über einen testgruppenübergreifenden Kurzschluß K3 mit dem Netzwerk NW4 verbunden.

Zum Aufladen eines Netzwerkes wird beispielsweise ein Primärelektronenstrahl auf einen Kontaktpunkt des Netzwerkes gerichtet. Eine andere Möglichkeit zur Aufladung des Netzwerkes besteht beispielsweise durch Ionenbestrahlung, Photoelektronenerzeugung durch Laserstrahlen oder in der Verwendung von Mikroelektroden. Zur Messung von Potentialen an Kontaktpunkten wird jeweils ein Primärelektronenstrahl, der in der Regel auch zur Aufladung benützt wird, auf den jeweiligen Kontaktpunkt gerichtet und dadurch ein Sekundärelektronenstrahl erzeugt. Zur Messung der Potentiale an den Kontaktpunkten wird der durch ein Gegenfeld in einen Detektor gelangende Sekundärelektronenstrom ausgewertet. Negativ geladene Kontaktpunkte beschleunigen die emittierten Sekundärelektronen, die dadurch das Gegenfeld überwinden können. Es resultiert dadurch ein hoher detektierter Strom und damit ein hohes Signal für geladene Kontaktpunkte, während sich ein niedriger Strom und damit ein niedriges Signal für ungeladene Kontaktpunkte ergibt. Die Messung der Potentiale an den Kontaktpunkten kann beispielsweise auch über Mikroelektroden erfolgen. In der Zeichnung ist beispielhaft auf den Kontaktpunkt 4 ein Primärelektronenstrahl PE1 zum Aufladen des Netzwerkes NW2 gerichtet. Ein auf den Kontaktpunkt 5 gerichteter Primärelektronenstrahl PE2 erzeugt Sekundärelektronen SE2, ein auf den Kontaktpunkt 6 gerichteter Primärelektronenstrahl PE3 erzeugt Sekundärelektronen SE3, ein auf den Kontaktpunkt 7 gerichteter Primärelektronenstrahl PE5 erzeugt Sekundärelektronen SE5, ein auf den Kontaktpunkt 10 gerichteter Primärelektronenstrahl PE6 erzeugt Sekundärelektronen SE6 und ein auf den Kontaktpunkt 17 gerichteter Primärelektronenstrahl PE7 erzeugt Sekundärelektronen SE7 über die jeweils die Potentiale der betreffenden Kontaktpunkte bestimmt werden. Geht man davon aus daß vor einem Test alle Kontaktpunkte ein Nullpotential besitzen, so beginnt der erste Schritt eines Haupttests zur Feststellung von Unterbrechungen in Netzwerken damit, daß jeweils ein noch nicht gezielt aufgeladenes Netzwerk, beispielsweise das Netzwerk NW2, über einen Kontaktpunkt, beispielsweise der Kontaktpunkt 4, des jeweiligen Netzwerkes gezielt auf ein vom Nullpotential verschiedenes Ladepotential aufgeladen wird. Die Ausdrücke "Nullpotential" und "Ladepotential" sind hier und im folgenden als Potentialbereiche aufzufassen, wobei die Potentialbereiche gegenseitig nicht überlappend sind. In einem zweiten Schritt des Haupttests zur Feststellung von Unterbrechungen in Netzwerken werden jeweils Potentiale von nicht gezielt aufgeladenen Kontaktpunkten des jeweiligen Netzwerkes, beispielsweise die Kontaktpunkte 5 und 6 des Netzwerkes NW2, gemessen. In einem dritten Schritt des Haupttests zur Feststellung einer Unterbrechung in einem Netzwerk, wird die jeweilige Unterbrechung dadurch festgestellt, daß ein Unterbrechungskontaktpunkt, des jeweiligen Netzwerkes nicht über eine Leitung, beispielsweise der Kontaktpunkt 6 über die Leitung L, des jeweiligen Netzwerkes auf das Ladepotential aufgeladen wurde. Durch Mikrofelder und/oder Oberflächenverunreinigungen können beispielsweise die Sekundärelektronen so beeinflußt werden, daß eine Unterbrechung nur vorgetäuscht wird. Um diesen Testfehler zu vermeiden, wird nach dem Haupttest ein erster erfindungsgemäßer Nachtest vorgenommen. Vor einem ersten erfindungsgemäßen Nachtest sind dabei alle Kontaktpunkte 1 ... 24 der Leiterplatte LP zu entladen. Das Entladen kann hier und im folgenden durch einen niederenergetischen positiven Ionenstrahl erfolgen, wenn die Kontaktpunkte negativ aufgeladen worden sind. Der erste erfindungsgemäße Nachtest selbst erfolgt dadurch, daß in einem ersten Schritt ein jeweiliger Unterbrechungskontaktpunkt, zum Beispiel der Kontaktpunkt 6, gezielt auf das Ladepotential aufgeladen wird, daß in einem zweiten Schritt Potentiale von in diesem Nachtest nicht gezielt aufgeladenen Kontaktpunkten, zum Beispiel die Kontaktpunkte 4 bzw. 5, des jeweiligen Netzwerkes, zum Beispiel des Netzwerkes NW2, gemessen werden. In einem dritten Schritt des ersten erfindungsgemäßen Nachtests werden die im Haupttest festgestellten jeweiligen Unterbrechungen bestätigt, wenn mindestens ein Kontaktpunkt, in der Zeichnung die beiden Kontaktpunkte 4 und 5, vom Netzwerk des jeweiligen Unterbrechungskontaktpunkts, hier das Netzwerk NW2 mit dem Unterbrechungskontaktpunkt 6, nicht über eine Leitung, des jeweiligen Netzwerkes auf das Ladepotential aufgeladen wurde. Wäre im Haupttest beispielsweise der Unterbrechungskontaktpunkt 6 festgestellt worden, ohne daß eine Unterbrechung U vorliegt, so wären beispielsweise die Kontaktpunkte 4 und 5 vom Netzwerk NW2 auf das Ladepotential aufgeladen und ein im Haupttest aufgetretener Testfehler festgestellt worden.

Bei einem Test zur Feststellung von Kurzschlüssen zwischen Netzwerken, wird unter der Annahme, daß vor Beginn eines Haupttests alle Kontaktpunkt das Nullpotential besitzen, in einem ersten Schritt des Haupttests jeweils ein noch nicht gezielt aufgeladenes Netzwerk, zum Beispiel das Netzwerk NW2, über mindestens einen Kontaktpunkt, zum Beispiel den Kontaktpunkt 4, des jeweiligen Netzwerkes gezielt auf ein vom Nullpotential verschiedenes Ladepotential aufgeladen. Im zweiten Schritt dieses Haupttests werden jeweils Potentiale von anderen noch nicht gezielt aufgeladenen Netzwerken, zum Beispiel das Netzwerk NW3, über mindestens einen Kontaktpunkt zum Beispiel den Kontaktpunkt 7, des jeweiligen anderen Netzwerkes gemessen. Hier wird in einem dritten Schritt des Haupttests ein jeweiliger Kurzschluß, zum Beispiel der Kurzschluß K1 von einem der bereits gezielt aufgeladenen Netzwerke, zum Beispiel NW1 und NW2, zu einem jeweiligen anderen noch nicht gezielt aufgeladenen Netzwerk, zum Beispiel dem Netzwerk NW3, dadurch festgestellt, daß mindestens ein Kurzschlußkontaktpunkt, zum Beispiel der Kontaktpunkt 7, des jeweiligen anderen noch nicht gezielt aufgeladenen Netzwerkes bereits über den jeweiligen Kurzschluß auf das Ladepotential aufgeladen wurde. Bei der Messung von Potentialen der Kontaktpunkte eines Netzwerkes kann ebenfalls, zum Beispiel durch Mikrofelder und chenverunreinigungen, ein geladenes Netzwerk und damit ein Kurzschluß, beispielsweise durch das Netzwerk NW3 ein Kurzschluß K1, vorgetäuscht werden. Um diesen Testfehler zu vermeiden wird ein zweiter erfindungsgemäßer Nachtest vorgesehen, bei dem, nachdem alle Kontaktpunkte 1 ... 24 entladen wurden, in einem ersten Schritt über einen jeweiligen Kurzschlußkontaktpunkt, zum Beispiel dem Kontaktpunkt 7, das Netzwerk, spielsweise das Netzwerk NW3, des jeweiligen Kurzschlußkontaktpunktes gezielt auf das Ladepotential aufgeladen wird und in einem zweiten Schritt Potentiale von in diesem Nachtest noch nicht gezielt aufgeladenen Netzwerken, beispielsweise den Netzwerken NW1 und NW2, dadurch ermittelt werden, daß jeweils das Potential über mindestens einen Kontaktpunkt, beispielsweise den Kontaktpunkt 2 bzw. 5, des jeweiligen im Nachtest noch nicht gezielt aufgeladenen Netzwerkes gemessen wird. In einem dritten Schritt des zweiten erfindungsgemäßen Nachtests wird dabei der jeweilige im dritten Schritt des Haupttests festgestellte Kurzschluß, zum Beispiel der Kurzschluß K1, bestätigt, wenn ein im Nachtest noch nicht gezielt aufgeladenes Netzwerk, zum Beispiel das Netzwerk NW2, über den jeweiligen Kurzschluß auf das Ladepotential aufgeladen wurde. Ohne den Kurzschluß K1 wären beispielsweise die Netzwerke NW1 und NW2 in diesem Fall nicht aufgeladen worden und der im Haupttest festgestellte Kurzschluß wäre nur aufgrund eines Testfehlers gemeldet worden. Der Test zur Feststellung von Unterbrechungen in Netzwerken und von Kurzschlüssen zwischen Netzwerken kann in der Weise kombiniert werden, daß nacheinander jeweils ein Netzwerk aufgeladen wird um eine Unterbrechung innerhalb des jeweiligen Netzwerkes festzustellen und daß anschließend noch nicht gezielt aufgeladene Netzwerke gemessen werden um Kurzschlüsse zwischen einem der bereits geladenen Netzwerke und dem jeweiligen Netzwerk festzustellen. Wurden beispielsweise die Netzwerke NW1 und NW2 im Haupttest bereits gezielt geladen, so kann beispielsweise das Netzwerk NW3, sofern es geladen ist aber nicht gezielt geladen wurde, durch einen Kurzschluß zum Netzwerk NW1 und/oder einen Kurzschluß zum Netzwerk NW2 geladen worden sein. Eine Feststellung der am jeweiligen Kurzschluß beteiligten Netzwerke ist also nicht in eindeutiger Weise möglich. Die in der Zeichnung vorgesehenen Kurzschlüsse K2 und K3 sind hierbei ohne Belang. Einem Haupttest zur Feststellung von Unterbrechungen in Netzwerken und Kurzschlüssen zwischen Netzwerken kann ein dritter erfindungsgemäßer Nachtest folgen, bei dem eingangs alle Kontaktpunkte 1 ... 24 der Leiterplatte LP entladen werden, bei dem in einem ersten Schritt über einen jeweiligen Kurzschlußkontaktpunkt, beispielsweise über den Kontaktpunkt 7, das Netzwerk des jeweiligen Kurzschlußkontaktpunktes, beispielsweise das Netzwerk NW3, gezielt auf das Ladepotential aufgeladen wird und bei in einem zweiten Schritt des Nachtests Potentiale von im Nachtest noch nicht gezielt aufgeladenen anderen Netzwerken, beispielsweise den Netzwerken NW1 und NW2, dadurch ermittelt werden, daß jeweils das Potential über mindestens einen Kontaktpunkt, beispielsweise den Kontaktpunkt 2 bzw. 5, des jeweiligen im Nachtest nicht gezielt aufgeladenen anderen Netzwerkes gemessen wird. In einem dritten Schritt des dritten erfindungsgemäßen Nachtests wird ein in einem fünften Schritt des Haupttests festgestellter jeweiliger Kurzschluß, beispielsweise der Kurzschluß K1, bestätigt und ein jeweiliges noch nicht gezielt aufgeladenes und am jeweiligen Kurzschluß beteiligtes anderes Netzwerk, zum Beispiel das Netzwerk NW2 eindeutig festgestellt und zusammen mit dem Netzwerk des jeweiligen Kurzschlußkontaktpunktes, zum Beispiel des Kontaktpunktes 7, gemeldet, wenn das im Nachtest nicht gezielt aufgeladene Netzwerk über den jeweiligen Kurzschluß auf das Ladepotential aufgeladen wurde. Durch diesen Nachtest ist also eine eindeutige Zuordnung der am jeweiligen Kurzschluß beteiligten Netzwerke möglich, obwohl gezielt aufgeladene Netzwerke nicht jeweils vor dem gezielten Aufladen eines anderen Netzwerkes gezielt entladen werden, sondern geladen bleiben. Wie bereits beim zweiten erfindungsgemäßen Nachtest können hier in entsprechender Weise Testfehler aufgrund von zum Beispiel Mikrofeldern und/oder Oberflächenverunreinigungen von echten Leiterplattenfehlern, wie zum Beispiel Unterbrechungen und Kurzschlüssen, unterschieden werden.

Da bereits gezielt aufgeladene Netzwerke sich störend auf eine Messung des Potentials eines anderen Netzwerkes auswirken können und die Netzwerke, aufgrund einer begrenzten Isolationsfähigkeit der Leiterplatte, nur begrenzte Zeit geladen bleiben, muß vor allem bei größeren Leiterplatten eine Zusammenfassung von zu testenden Netzwerken zu Testgruppen erfolgen. Da maximal nur alle Netzwerke einer Testgruppe gleichzeitig geladen sind, sind beispielsweise mehr Endladeschritte und zusätzliche Schritte zur Feststellung von Kurzschlüssen zwischen Testgruppen erforderlich und bedeuten zusätzlichen Aufwand. Aus diesem Grund wird eine Testgruppe nicht beliebig klein sein können. Ab einer gewissen Größe der Testgruppe kann es unter Umständen vorkommen, daß aufgrund von Fehlern, beispielsweise nicht ausreichender Isolationsfähigkeit der Leiterplatte oder Ladungswolken über dem jeweiligen Netzwerk, zu einer Entladung des Netzwerkes führen, bevor eine Testgruppe vollständig getestet ist. Geht man davon aus daß nur der Kurzschluß K2 zwischen den Netzwerken NW1 und NW2 besteht und daß zu Beginn eines Haupttests der Testgruppe TG1 das Netzwerk NW1 gezielt aufgeladen wird, so kann das Netzwerk NW1 bereits wieder entladen sein, wenn beispielsweise das Potential des Netzwerkes NW2 zur Feststellung eines Kurzschlusses gemessen wird. Das Netzwerk NW1 kann also über den Kurzschluß K2 das Netzwerk NW2 nicht mehr aufladen, wodurch der Kurzschluß K2 im Haupttest unentdeckt bleibt. Zur Vermeidung dieses Testfehlers kann nach dem Haupttest zur Feststellung von Unterbrechungen in Netzwerken und Kurzschlüssen zwischen Netzwerken ein Zwischentest schentest zwischen dem Haupttest und seinem nachfolgenden vorgesehen werden. Im erfindungsgemäßen Zwischentest werden bereits wieder ungeladene Netzwerke, wie zum Beispiel das Netzwerk NW1, innerhalb der jeweiligen Testgruppe TG1 dadurch ermittelt, daß jeweils das Potential von mindestens einem Kontaktpunkt eines jeweiligen Netzwerkes, zum Beispiel dem Kontaktpunkt 2 des Netzwerkes NW1, gemessen und festgestellt wird, ob das Potential dem Ladepotential entspricht. Für die im Zwischentest ermittelten ungeladenen Netzwerke, die nicht zur Feststellung von Kurzschlüssen geeignet waren, wird jeweils ein Nachtest durchgeführt, der darin besteht, daß der dritte erfindungsgemäße Nachtest durchgeführt wird, wobei anstelle der Netzwerke mit den Kurzschlußkontaktpunkten oder zusätzlich zu den Netzwerken mit den Kurzschlußkontaktpunkten die im vorangegangenen erfindungsgemäßen Zwischentest ermittelten Netzwerke diesem Nachtest unterzogen werden. So wird beispielsweise das im Zwischentest ermittelte Netzwerk NW1 gezielt aufgeladen und der Kurzschluß K2 zum Netzwerk NW2 ermittelt, obwohl das Netzwerk NW1 im Haupttest bereits entladen war.

Werden mehrere Testgruppen gebildet, so können auch testgruppenübergreifende Kurzschlüsse zwischen Netzwerken unterschiedlicher Testgruppen, wie beispielsweise der testgruppenübergreifende Kurzschluß K3 zwischen den Netzwerken NW2 und NW4, auftreten. In einem weiteren erfindungsgemäßen Zwischentest werden jeweils die Potentiale von Netzwerken anderer Testgruppen, beispielsweise von den Netzwerken NW4 ... NW9 der Testgruppen TG2 und TG3, über mindestens einen Kontaktpunkt des jeweiligen Netzwerkes der anderen Testgruppe, beispielsweise den Kontaktpunkt 10 des Netzwerkes NW4 der Testgruppe TG2, gemessen. In einem zweiten Schritt des jeweiligen weiteren Zwischentests wird ein jeweiliger testgruppenübergreifender Kurzschluß von einem der im jeweiligen Haupttest bereits gezielt aufgeladenen Netzwerke der jeweiligen Testgruppe zu einem jeweiligen Netzwerk der anderen Testgruppe dadurch festgestellt, daß mindestens ein testgruppenübergreifender Kurzschlußkontaktpunkt des jeweiligen Netzwerkes der anderen Testgruppe bereits über den jeweiligen testgruppenübergreifenden Kurzschluß auf das Ladepotential aufgeladen wurde. Der testgruppenübergreifende Kurzschluß K3 wird beispielsweise dadurch festgestellt daß mindestens beispielsweise der Kurzschlußkontaktpunkt 10 des Netzwerkes NW4 der Testgruppe TG2 bereits über den testgruppenübergreifenden Kurzschluß K3 auf das Ladepotential aufgeladen wurde.

Wurde in dem weiteren Zwischentest mindestens ein testgruppenübergreifender Kurzschlußkontaktpunkt bzw. ein testgruppenübergreifender Kurzschluß, beispielsweise der Kurzschlußkontaktpunkt 10 und der Kurzschluß K3, festgestellt, so können erfindungsgemäß als dritter Schritt des jeweiligen Zwischentests alle Kontaktpunkte 1 ... 24 der Leiterplatte entladen werden bevor auch in diesem Fall ein erfindungsgemäßer Nachtest durchgeführt wird, um gegebenenfalls einen Kurzschluß zu bestätigen oder einen Testfehler festzustellen. Bei diesem erfindungsgemäßen Nachtest wird in einem ersten Schritt beispielsweise über den testgruppenübergreifenden Kurzschlußkontaktpunkt 10 das Netzwerk NW2 gezielt auf das Ladepotential aufgeladen, in einem zweiten Schritt werden Potentiale von im Nachtest noch nicht gezielt aufgeladenen Netzwerken NW1 ... NW3 und NW7 ... NW9 der Testgruppen TG1 und TG3 dadurch ermittelt, daß jeweils das Potential über mindestens einen Kontaktpunkt 2, 4, 7, 17, 20 und 22 gemessen wird und in einem dritten Schritt wird ein in einem zweiten Schritt des weiteren erfindungsgemäßen Zwischentests festgestellter jeweiliger testgruppenübergreifender Kurzschluß K3 bestätigt, wenn ein im Nachtest noch nicht gezielt aufgeladenes Netzwerk der jeweiligen anderen Testgruppe, beispielsweise das Netzwerk NW2 der Testgruppe TG1, über den jeweiligen testgruppenübergreifenden Kurzschluß K3 auf das Ladepotential aufgeladen wurde. Falls der testgruppenübergreifende Kurzschluß K3 im erfindungsgemäßen Nachtest nicht bestätigt wird liegt ein Testfehler vor.

## Patentansprüche

1. Verfahren zur Erkennung von Testfehlern beim Test, insbesondere Elektronenstrahltest, von Mikroverdrahtungen in Form einer Leiterplatte (LP) mit einer Mehrzahl von Netzwerken (NW1 ... NW9), wobei jedes Netzwerk eine Mehrzahl von Kontaktpunkten (1 ... 24) besitzt, bei dem Unterbrechungen (U) in Netzwerken festgestellt werden, bei dem vor Beginn eines Haupttests alle Kontaktpunkte ein Nullpotential besitzen, bei dem in einem ersten Schritt des Haupttests jeweils ein noch nicht gezielt aufgeladenes Netzwerk (NW2) über einen Kontaktpunkt (4) des jeweiligen Netzwerkes gezielt auf ein vom Nullpotential verschiedenes Ladepotential aufgeladen wird, bei dem in einem zweiten Schritt des Haupttests jeweils Potentiale von nicht gezielt aufgeladenen Kontaktpunkten (5, 6) des jeweiligen Netzwerkes (NW2) gemessen werden und bei dem in einem dritten Schritt des Haupttests eine Unterbrechung (U) im jeweiligen Netzwerk (NW2) dadurch festgestellt wird, daß ein Kontaktpunkt (6) des jeweiligen Netzwerkes nicht über eine Leitung (L) des jeweiligen Netzwerkes auf das Ladepotential aufgeladen wurde, **dadurch gekennzeichnet**, daß vor einem Nachtest alle Kontaktpunkte (1 ... 24) entladen werden, daß in einem ersten Schritt des Nachtests ein jeweiliger Kontaktpunkt (6), bei dem im Haupttest eine Unterbrechung festgestellt wurde, gezielt auf das Ladepotential aufgeladen wird, daß in einem zweiten Schritt des Nachtests Potentiale von im Nachtest nicht gezielt aufgeladenen Kontaktpunkten (4, 5) des jeweiligen Netzwerkes (NW2) gemessen werden, daß in einem dritten Schritt des Nachtests eine in einem dritten Schritt des Haupttests festgestellte jeweilige Unterbrechung (U) bestätigt wird, wenn mindestens ein Kontaktpunkt (4, 5) des jeweiligen Netzwerkes (NW2) nicht über eine Leitung (L) des jeweiligen Netzwerkes (NW2) auf das Ladepotential aufgeladen wurde, und daß jeweils ein im Haupttest aufgetretener Testfehler festgestellt wird, wenn die im dritten Schritt des Haupttests festgestellte jeweilige Unterbrechung nicht bestätigt wird.

2. Verfahren zur Erkennung von Testfehlern beim Test, insbesondere Elektronenstrahltest, von Mikroverdrahtungen in Form einer Leiterplatte (LP) mit einer Mehrzahl von Netzwerken (NW1 ... NW9), wobei jedes Netzwerk eine Mehrzahl von Kontaktpunkten (1 ... 24) besitzt, bei dem Kurzschlüsse (K1) zwischen Netzwerken festgestellt werden, bei dem vor Beginn eines Haupttests alle Kontaktpunkte ein Nullpotential besitzen, bei dem in einem ersten Schritt des Haupttests jeweils ein noch nicht gezielt aufgeladenes Netzwerk (NW2) über mindestens einen Kontaktpunkt (4) des jeweiligen Netzwerkes (NW2) gezielt auf ein vom Nullpotential verschiedenes Ladepotential aufgeladen wird, bei dem in einem zweiten Schritt des Haupttests jeweils die Potentiale von anderen noch nicht gezielt aufgeladenen Netzwerken (NW3) über mindestens einen Kontaktpunkt (7) des jeweiligen anderen Netzwerkes (NW3) gemessen werden und bei dem in einem dritten Schritt des Haupttests ein jeweiliger Kurzschluß (K1) von einem der bereits gezielt aufgeladenen Netzwerke (NW1, NW2) zu einem jeweiligen anderen noch nicht gezielt aufgeladenen Netzwerk (NW3) dadurch festgestellt wird, daß mindestens ein Kontaktpunkt (7) des jeweiligen anderen noch nicht gezielt aufgeladenen Netzwerkes (NW3) bereits über den jeweiligen Kurzschluß (K1) auf das Ladepotential aufgeladen wurde, **dadurch gekennzeichnet,** daß vor einem Nachtest alle Kontaktpunkte (1 ... 24) entladen werden, daß in einem ersten Schritt des Nachtests über einen jeweiligen Kontaktpunkt (7), bei dem im Haupttest ein Kurzschluß festgestellt wurde, das Netzwerk (NW3) dieses Kontaktpunktes (7) gezielt auf das Ladepotential aufgeladen wird, daß in einem zweiten Schritt des Nachtests Potentiale von im Nachtest noch nicht gezielt aufgeladenen Netzwerken (NW1, NW2) dadurch ermittelt werden, daß jeweils das Potential über mindestens einen Kontaktpunkt (2, 5) des jeweiligen im Nachtest noch nicht gezielt aufgeladenen Netzwerkes (NW1, NW2) gemessen wird, daß in einem dritten Schritt des Nachtests ein in einem dritten Schritt des Haupttests festgestellter jeweiliger Kurzschluß (K1) bestätigt wird, wenn ein im Nachtest noch nicht gezielt aufgeladenes Netzwerk (NW2) über den jeweiligen Kurzschluß (K1) auf das Ladepotential aufgeladen wurde, und daß jeweils ein im Haupttest aufgetretener Testfehler festgestellt wird, wenn der in einem dritten Schritt des Haupttests festgestellte jeweilige Kurzschluß nicht bestätigt wird.

3. Verfahren zur Erkennung von Testfehlern beim Test, insbesondere Elektronenstrahltest, von Mikroverdrahtungen in Form einer Leiterplatte (LP) mit einer Mehrzahl von Netzwerken (NW1 ... NW9), wobei jedes Netzwerk eine Mehrzahl von Kontaktpunkten (1 ... 24) besitzt, bei dem Unterbrechungen (U) in Netzwerken (NW2) und Kurzschlüsse zwischen Netzwerken (NW2, NW3) festgestellt werden, bei dem vor Beginn eines Haupttests alle Kontaktpunkte ein Nullpotential besitzen, bei dem in einem ersten Schritt des Haupttests jeweils ein noch nicht gezielt aufgeladenes Netzwerk (NW2) über einen Kontaktpunkt (4) des jeweiligen Netzwerkes gezielt auf ein vom Nullpotential verschiedenes Ladepotential aufgeladen wird, bei dem in einem zweiten Schritt des Haupttests jeweils Potentiale von nicht gezielt aufgeladenen Kontaktpunkten (5, 6) des jeweiligen Netzwerkes (NW2) gemessen werden, bei dem in einem dritten Schritt des Haupttests eine Unterbrechung (U) im jeweiligen Netzwerk (NW2) dadurch festgestellt wird, daß ein Kontaktpunkt (6) des jeweiligen Netzwerkes nicht über eine Leitung (L) des jeweiligen Netzwerkes auf das Ladepotential aufgeladen wurde, bei dem in einem vierten Schritt des Haupttests jeweils die Potentiale von anderen noch nicht gezielt aufgeladenen Netzwerken (NW3) über mindestens einen Kontaktpunkt (7) des jeweiligen anderen Netzwerkes (NW3) gemessen werden und bei dem in einem fünften Schritt des Haupttests ein jeweiliger Kurzschluß (K1) von einem der bereits gezielt auf das Ladepotential aufgeladenen Netzwerke (NW1, NW2) zu einem jeweiligen anderen noch nicht gezielt aufgeladenen Netzwerk (NW3) dadurch festgestellt wird, daß mindestens ein Kontaktpunkt (7) des jeweiligen anderen noch nicht gezielt aufgeladenen Netzwerkes (NW3) bereits über den jeweiligen Kurzschluß (K1) auf das Ladepotential aufgeladen wurde, **dadurch gekennzeichnet**, daß vor einem Nachtest alle Kontaktpunkte (1 ... 24) der Leiterplatte (LP) entladen werden, daß in einem ersten Schritt des Nachtests über einen jeweiligen Kontaktpunkt (7), bei dem im Haupttest ein Kurzschluß festgestellt wurde, das Netzwerk (NW3) dieses Kontaktpunktes (7) gezielt auf das Ladepotential aufgeladen wird, daß in einem zweiten Schritt des Nachtests Potentiale von im Nachtest noch nicht gezielt aufgeladenen anderen Netzwerken (NW1, NW2) dadurch ermittelt werden, daß jeweils das Potential über mindestens einen Kontaktpunkt (2, 5) des jeweiligen im Nachtest noch nicht gezielt aufgeladenen anderen Netzwerkes (NW1, NW2) gemessen wird, daß in einem dritten Schritt eines Nachtests ein in einem fünften Schritt des Haupttests festgestellter jeweiliger Kurzschluß (K1) bestätigt und ein jeweiliges noch nicht gezielt aufgeladenes und am jeweiligen Kurzschluß (K1) beteiligtes anderes Netzwerk (NW2) eindeutig festgestellt und zusammen mit dem Netzwerk (NW3) des jeweiligen Kontaktpunktes (7), bei dem Haupttest ein Kurzschluß festgestellt wurde, gemeldet wird, wenn das im Nachtest noch nicht gezielt aufgeladene Netzwerk (NW3) über den jeweiligen Kurzschluß (K1) auf das Ladepotential aufgeladen wurde, und daß jeweils ein im Haupttest aufgetretener Testfehler festgestellt wird, wenn der in einem fünften Schritt des Haupttests festgestellte jeweilige Kurzschluß nicht bestätigt wird.

4. Verfahren nach Anspruch 3 **dadurch gekennzeichnet**, daß die Mehrzahl der Netzwerke zu mindestens einer Testgruppe (TG1, TG2, TG3) zusammengefaßt werden und daß der Haupttest jeweils für eine Testgruppe (TG1) durchgeführt und durch einen jeweiligen Zwischentest ergänzt wird, wobei im Zwischentest aufgrund eines Fehlers bereits wieder ungeladene Netzwerke (NW1) innerhalb der jeweiligen Testgruppe (TG1) dadurch ermittelt werden, daß jeweils das Potential von mindestens einem Kontaktpunkt (2) eines jeweiligen Netzwerkes (NW1) gemessen und festgestellt wird, ob das Potential dem Ladepotential entspricht, daß vor einem Nachtest alle Kontaktpunkte (1 ... 24) entladen werden, daß in einem ersten Schritt des Nachtests jeweils ein im Zwischentest ermitteltes Netzwerk (NW1) gezielt auf das Ladepotential aufgeladen wird, daß in einem zweiten Schritt des Nachtests über jeweils mindestens einen Kontaktpunkt (5, 7) Potentiale von anderen Netzwerken (NW2, NW3) der jeweiligen Testgruppe (T1) gemessen werden und daß in einem dritten Schritt des Nachtests ein Kurzschluß (K2) ermittelt und ein jeweiliges am Kurzschluß (K2) beteiligtes anderes Netzwerk (NW2) eindeutig festgestellt und zusammen mit dem jeweiligen im ersten Schritt des Nachtests gezielt aufgeladenen und ebenfalls am Kurzschluß (K2) beteiligten Netzwerk (NW1) gemeldet wird, wenn das im Nachtest noch nicht gezielt aufgeladene Netzwerk (NW1) über den Kurzschluß (K2) auf das Ladepotential aufgeladen wurde.

5. Verfahren nach Anspruch 4, **dadurch gekennzeichnet**, daß in einem ersten Schritt eines jeweiligen Zwischentests jeweils die Potentiale von Netzwerken (NW4 ... NW9) anderer Testgruppen (TG2, TG3), über mindestens einen Kontaktpunkt (10, 12, 15, 17, 20 und 22) des jeweiligen Netzwerkes (NW4) der anderen Testgruppe (TG2) gemessen werden, daß in einem zweiten Schritt des jeweiligen Zwischentests ein jeweiliger testgruppenübergreifender Kurzschluß (K3) von einem der im jeweiligen Haupttest bereits gezielt aufgeladenen Netzwerke (NW2) der jeweiligen Testgruppe (TG1) zu einem jeweiligen Netzwerk (NW4) der anderen Testgruppe (TG2) dadurch festgestellt wird, daß mindestens ein Kontaktpunkt (10) des jeweiligen Netzwerkes (NW4) der anderen Testgruppe (TG2) bereits über den jeweiligen testgruppenübergreifenden Kurzschluß (K3) auf das Ladepotential aufgeladen wurde.

6. Verfahren nach Anspruch 5, **dadurch gekennzeichnet**, daß als dritter Schritt eines jeweiligen Zwischentests alle Kontaktpunkte (1 ... 24) der Leiterplatte (LP) entladen werden, daß in einem ersten Schritt eines Nachtests über einen jeweiligen testgruppenübergreifenden Kurzschluß das Netzwerk (NW4) des jeweiligen testgruppenübergreifenden Kontaktpunktes (10), bei dem im Zwischentest ein testgruppen übergreifender Kurzschluß festgestellt wurde, gezielt auf das Ladepotential aufgeladen wird, daß in einem zweiten Schritt des Nachtests Potentiale von im Nachtest noch nicht gezielt aufgeladenen Netzwerken (NW1 ... NW3, NW7 ... NW9) einer jeweiligen anderen Testgruppe (TG1, TG3) dadurch ermittelt werden, daß jeweils das Potential über mindestens einen Kontaktpunkt (2, 4, 7, 17, 20, 22) des jeweiligen im Nachtest noch nicht gezielt aufgeladenen Netzwerkes (NW1 ... NW3, NW7 ... NW9) der jeweiligen anderen Testgruppe (TG1, TG3) gemessen wird, daß in einem dritten Schritt des Nachtests ein in einem zweiten Schritt Zwischentests festgestellter jeweiliger testgruppenübergreifender Kurzschluß (K3) bestätigt wird, wenn ein im Nachtest noch nicht gezielt aufgeladenes Netzwerk (NW2) der jeweiligen anderen Testgruppe (TG1) über den jeweiligen testgruppenübergreifenden Kurzschluß (K3) auf das Ladepotential aufgeladen wurde, und daß ein Testfehler festgestellt wird, wenn der in einem dritten Schritt des Haupttests festgestellte Kurzschluß nicht bestätigt wird.

## Claims

1. Method for the recognition of testing errors in the testing, particularly electron beam testing, of microwirings in the form of a printed circuit board (LP) with a plurality of networks (NW1 ... NW9), each network having a plurality of contact points (1 ... 24), wherein interruptions (U) are identified in the networks, wherein all contact points have a zero potential before the beginning of the main test, wherein in a first step of the main test in each case a network (NW2) which has not yet been intentionally charged is intentionally charged to a charging potential which is different from the zero potential via a contact point (4) of the particular network, wherein in a second step of the main test in each case potentials of contact points (5, 6) which are not intentionally charged in the particular network (NW2) are measured and wherein in a third step of the main test an interruption (U) is identified in the particular network (NW2) in that a contact point (6) of the particular network had not been charged to the charging potential via a line (L) of the particular network, characterised in that before a follow-up test all contact points (1 ... 24) are discharged, in a first step of the follow-up test a particular contact point (6) in respect of which an interruption had been identified in the main test is intentionally charged to the charging potential, in a second step of the follow-up test potentials of contact points (4, 5) of the particular network (NW2) which were not intentionally charged in the follow-up test are measured, in a third step of the follow-up test a particular interruption (U) identified in a third step of the main test is confirmed if at least one contact point (4, 5) of the particular network (NW2) has not been charged to the charging potential via a line (L) of the particular network (NW2), and in each case a testing error which occurred in the main test is identified if the particular interruption identified in the third step of the main test is not confirmed.

2. Method for the recognition of testing errors in the testing, particularly electron beam testing, of microwirings in the form of a printed circuit board (LP) with a plurality of networks (NW1 ... NW9), each network having a plurality of contact points (1 ... 24), wherein short circuits (K1) between networks are identified, wherein before the beginning of a main test all contact points are at zero potential, wherein in a first step of the main test a network (NW2) which has not yet been intentionally charged is in each case charged to a charging potential which is different from the zero potential via at least one contact point (4) of the particular network (NW2), wherein in a second step of the main test the potentials of other networks (NW3) which have not yet been intentionally charged are in each case measured via at least one contact point (7) of the particular other network (NW3), and wherein in a third step of the main test a particular short circuit (K1) from one of the networks (NW1, NW2) which has already been intentionally charged to a particular other network (NW3) which has not yet been intentionally charged is identified in that at least one contact point (7) of the particular other network which has not yet been intentionally charged had already been charged to the charging potential via the particular short circuit (K1), characterised in that before a follow-up test all contact points (1 ... 24) are discharged, in a first step of the follow-up test the network (NW3) of the contact point (7) in respect of which a short circuit had been identified in the main test is intentionally charged to the charging potential via this contact point (7), in a second step of the follow-up test potentials of networks (NW1, NW2) which have not yet been intentionally charged in the follow-up test are determined in each case by measuring the potential via at least one contact point (2, 5) of the particular network (NW1, NW2) which has not yet been intentionally charged in the follow-up test, in a third step of the follow-up test a particular short circuit (K1) identified in a third step of the main test is confirmed if a network (NW2) which has not yet been intentionally charged in the follow-up test was charged to the charging potential via the particular short circuit (K1), and in each case a testing error which occurred in the main test is identified if the particular short circuit identified in a third step of the main test is not confirmed.

3. Method for the recognition of testing errors in the testing, particularly electron beam testing, of microwirings in the form of a printed circuit board (LP) with a plurality of networks (NW1 ... NW9), each network having a plurality of contact points (1 ... 24), wherein interruptions (U) in networks (NW2) and short circuits between networks (NW2, NW3) are identified, wherein before the beginning of a main test all contact points are at zero potential, wherein in a first step of the main test a network (NW2) which has not yet been intentionally charged is in each case charged to a charging potential which is different from the zero potential via a contact point (4) of the particular network, wherein in a second step of the main test potentials of other contact points (5, 6) which have not been intentionally charged in the particular network (NW2) are measured in each case, wherein in a third step of the main test an interruption (U) in the particular network (NW2) is identified in that a contact point (6) of the particular network had not been charged to the charging potential via a line (L) of the particular network, wherein in a fourth step of the main test the potentials of other networks (NW3) which have not yet been intentionally charged are in each case measured via at least one contact point (7) of the particular other network (NW3), and wherein in a fifth step of the main test a particular short circuit (K1) from one of the networks (NW1, NW2) which has already been charged to the charging potential to a particular other network (NW3) which has not yet been intentionally charged is identified in that at least one contact point (7) of the particular other network (NW3) which has not yet been intentionally charged had already been charged to the charging potential via the particular short circuit (K1), characterised in that before a follow-up test all contact points (1 ... 24) of the printed circuit board (LP) are discharged, in a first step of the follow-up test the network (NW3) of the contact point (7) in respect of which a short circuit had been identified in the main test is intentionally charged to the charging potential via this contact point (7), in a second step of the follow-up test potentials of other networks (NW1, NW2) which have not yet been intentionally charged in the follow-up test are determined in each case by measuring the potential via at least one contact point (2, 5) of the particular other network (NW1, NW2) which has not yet been intentionally charged in the follow-up test, in a third step of the follow-up test a particular short circuit (K1) identified in a fifth step of the main test is confirmed and a particular other network (NW2) which has not yet been intentionally charged and which participates in the particular short circuit (K1) is unambiguously identified and is reported together with the network (NW3) of the particular contact point (7) in respect of which a short circuit had been identified in the main test if the network (NW3) which has not yet been intentionally charged in the follow-up test was charged to the charging potential via the particular short circuit (K1), and in each case a testing error which occurred in the main test is identified if the particular short circuit identified in a fifth step of the main test is not confirmed.

4. Method as claimed in Claim 3, characterised in that the plurality of networks are combined into at least one test group (TG1, TG2, TG3) and the main test is carried out in each case for one test group (TG1) and supplemented by a particular intermediate test, wherein in the intermediate test networks (NW1) which are already uncharged again due to an error are identified within the particular test group (TG1) by in each case measuring the potential of at least one contact point (2) of a particular network (NW1) and determining whether the potential corresponds to the charging potential, before a follow-up test all contact points (1 ... 24) are discharged, in a first step of the follow-up test a network (NW1) identified in in the intermediate test is in each case charged to the charging potential, in a second step of the follow-up test potentials of other networks (NW2, NW3) of the particular test group (T1) are measured via at least one contact point (5, 7), and in a third step of the follow-up test a short circuit (K2) is identified and a particular other network (NW2) participating in the short circuit (K2) is unambiguously identified and reported together with the particular network (NW1) which was intentionally charged in the first step of the follow-up test and likewise participated in the short circuit (K2) if the network (NW1) which has not yet been intentionally charged in the follow-up test had been charged to the charging potential via the short circuit (K2).

5. Method as claimed in claim 4, characterised in that in a first step of a particular intermediate test the potentials of networks (NW4 ... NW9) of other test groups (TG2, TG3) are in each case measured via at least one contact point (10, 12, 15, 17, 20 and 22) of the particular network (NW4) of the other test group (TG2), in a second step of the particular intermediate test a particular short circuit (K3) which overlaps test groups from one of the networks (NW2) of the particular test group (TG1) already intentionally charged in the main test to a particular network (NW4) of the other test group (TG2) is identified in that at least one contact point (10) of the particular network (NW4) of the other test group (TG2) has already been charged to the charging potential via the particular short circuit (K3) which overlaps test groups.

6. Method as claimed in Claim 5, characterised in that as a third step of a particular intermediate test all contact points (1 ... 24) of the printed circuit board (LP) are discharged, in a first step of a follow-up test the network (NW4) of the particular contact point (10) which overlaps test groups and in respect of which a short circuit which overlaps test groups had been identified in the intermediate test is intentionally charged to the charging potential via a particular short circuit which overlaps test groups, in a second step of the follow-up test potentials of networks (NW1 ... NW3, NW7 ... NW9) of a particular other test group (TG1, TG3) which have not yet been intentionally charged in the follow-up test are identified in each case by measuring the potential via at least one contact point (2, 4, 7, 17, 20, 22) of the particular network (NW1 ... NW3, NW7 ... NW9) of a particular other test group (TG1, TG3) which has not yet been intentionally charged in the follow-up test, in a third step of the follow-up test a particular short circuit (K3) which overlaps test groups and had been identified in a second step of the intermediate test is confirmed if a network (NW2) of the particular other test group (TG1) which has not yet been intentionally charged in the follow-up test had been charged to the charging potential via the particular short circuit (K3) which overlaps test groups, and a testing error is identified if the short circuit identified in a third step of the main test is not confirmed.

## Revendications

1. Procédé d'identification d'erreurs de contrôle au cours d'un essai, en particulier d'un essai par faisceau électronique, de micro-câblages ayant la forme d'une carte de circuits imprimés (LP) comprenant de multiples réseaux (NW1...NW9), chaque réseau comprenant de multiples points de contact (1...24), contrôle au cours duquel des coupures (U) sont détectées dans les réseaux, au cours duquel tous les points de contact sont à un potentiel nul avant le début d'un contrôle principal, au cours duquel, à une première étape du contrôle principal, dans chaque cas un réseau spécifiquement non encore chargé (NW2) est spécifiquement chargé à un potentiel de charge différent du potentiel nul par un point de contact (4) du réseau particulier, au cours duquel, à une deuxième étape du contrôle principal, dans chaque cas des potentiels de points de contact spécifiquement non chargés (5, 6) du réseau particulier (NW2) sont mesurés et au cours duquel, à une troisième étape du contrôle principal, une coupure (U) existant dans le réseau particulier (NW2) est détectée par le fait qu'un point de contact (6) du réseau particulier n'a pas été chargé au potentiel de charge par un conducteur (L) du réseau particulier, caractérisé en ce que tous les points de contact (1...24) sont déchargés avant un test ultérieur, en ce qu'à une première étape du test ultérieur, un point de contact particulier (6) auquel une coupure a été détectée au cours du contrôle principal est spécifiquement chargé au potentiel de charge, en ce qu'à une deuxième étape du test ultérieur, des potentiels de points de contact (4, 5) du réseau particulier (NW2) qui n'ont spécifiquement pas été chargés au cours du test ultérieur sont mesurés, en ce qu'à une troisième étape du test ultérieur, une coupure particulière (U) détectée à la troisième étape du contrôle principal est confirmée lorsqu'au moins un point de contact (4, 5) du réseau particulier (NW2) n'a pas été chargé au potentiel de charge par un conducteur (L) du réseau particulier (NW2) et en ce que, dans chaque cas, une erreur de test qui est apparue au cours du contrôle principal est détectée lorsque la coupure particulière détectée à la troisième étape du contrôle principal n'est pas confirmée.

2. Procédé d'identification d'erreurs de contrôle au cours d'un essai, en particulier d'un essai par faisceau électronique, de micro-cablâges ayant la forme d'une carte de circuits imprimés (LP) comprenant de multiples réseaux (NW1...NW9), chaque réseau comprenant de multiples points de contact (1...24), essai au cours duquel des courts-circuits (K1) sont détectés entre réseaux, au cours duquel tous les points de contact sont à un potentiel nul avant le début d'un contrôle principal, au cours duquel, à une première étape du contrôle principal, dans chaque cas un réseau (NW2) spécifiquement non encore chargé est chargé spécifiquement à un potentiel de charge, qui est différent du potentiel nul, par au moins un point de contact (4) du réseau particulier NW2 , au cours duquel, à une deuxième étape du contrôle principal, chacun des potentiels d'autres réseaux (NW3) spécifiquement non encore chargés sont mesurés par au moins un point de contact (7) de l'autre réseau particulier (NW3) et au cours duquel, à une troisième étape du contrôle principal, un court-circuit particulier (K1) de l'un des réseaux (NW1, NW2) déjà spécifiquement chargés avec un autre réseau particulier (NW3) spécifiquement non encore chargé est décelé par le fait qu'au moins un point de contact (7) de l'autre réseau particulier (NW3) spécifiquement non encore chargé a déjà été chargé au potentiel de charge par le court-circuit particulier (K1), caractérisé en ce que tous les points de contact (1...24) sont déchargés avant un test ultérieur, en ce qu'à une première étape du test ultérieur, le réseau (NW3) auquel appartient un point de contact (7) est chargé spécifiquement au potentiel de charge par ce point de contact particulier (7) auquel le court-circuit a été détecté au cours du contrôle principal, en ce que, à une deuxième étape du test ultérieur, des potentiels de réseaux (NW1, NW2) qui n'ont spécifiquement pas été chargés au cours du test ultérieur sont déterminés par le fait que dans chaque cas le potentiel est mesuré par au moins un point de contact (2, 5) du réseau particulier (NW1, NW2) qui n'a spécifiquement pas encore été chargé au cours du test ultérieur, en ce qu'à une troisième étape du test ultérieur, un court-circuit particulier (K1) détecté à une troisième étape du contrôle principal est confirmé lorsqu'un réseau (NW2) spécifiquement non encore chargé au cours du test ultérieur a été chargé au potentiel de charge par le court-circuit particulier (K1) et en ce qu'une erreur de test apparue au cours du test principal est détectée lorsque le court-circuit particulier, détecté à une troisième étape du contrôle principal, n'est pas confirmé.

3. Procédé d'identification d'erreurs de contrôle au cours d'un essai, en particulier d'un essai par faisceau électronique, de micro-câblages ayant la forme d'une carte de circuits imprimés (LP) comprenant plusieurs réseaux (NW1...NW9), chaque réseau comprenant plusieurs points de contact (1...24), essai au cours duquel des coupures (U) sont détectées dans des réseaux (NW2) et des courts-circuits sont détectés entre réseaux (NW2, W3), tous les points de contact étant à un potentiel nul avant le début du contrôle principal, essai au cours duquel, à une première étape du contrôle principal, dans chaque cas, un réseau (NW2) spécifiquement non encore chargé est chargé spécifiquement à un potentiel de charge différent du potentiel nul par un point de contact (4) du réseau particulier, au cours duquel, à une deuxième étape du contrôle principal, chacun des potentiels de points de contact (5, 6) spécifiquement non chargés du réseau particulier (NW2) sont mesurés, au cours duquel, à une troisième étape du contrôle principal, une coupure (U) du réseau particulier (NW2) est détectée par le fait qu'un point de contact (6) du réseau particulier n'a pas été chargé au potentiel de charge par un conducteur (L) du réseau particulier, au cours duquel, à une quatrième étape du contrôle principal, chacun des potentiels d'autres réseaux (NW3) spécifiquement non encore chargés sont mesurés par au moins un point de contact (7) de l'autre réseau particulier (NW3) et au cours duquel, à une cinquième étape du contrôle principal, un court-circuit particulier (K1) d'un réseau (NW1, NW2), qui a déjà été chargé spécifiquement au potentiel de charge, avec un autre réseau particulier spécifiquement non encore chargé est détecté par le fait qu'au moins un point de contact (7) de l'autre réseau particulier (NW3) spécifiquement non encore chargé a déjà été chargé au potentiel de charge par le court-circuit particulier (NW1), caractérisé en ce que tous les points de contact (1..24) de la carte de circuits imprimés (LP) sont déchargés avant un test ultérieur, à ce qu'à une première étape du test ultérieur, le réseau (NW3) d'un point de contact particulier (7) est chargé spécifiquement au potentiel de charge par ce point de contact (7) auquel un court-circuit a été détecté au cours du contrôle principal, à ce qu'à une deuxième étape du test ultérieur, des potentiels d'autres réseaux (NW1,NW2) spécifiquement non encore chargés au cours du test ultérieur sont déterminés par le fait que dans chaque cas le potentiel est mesuré par au moins un point de contact (2, 5) de l'autre réseau particulier (NW1, NW2) spécifiquement non encore chargé au cours du test ultérieur, en ce qu'à une troisième étape d'un test ultérieur, un court-circuit particulier (K1) détecté à une cinquième étape du contrôle principal est confirmé et un autre réseau particulier (NW2) spécifiquement non encore chargé et participant au court-circuit particulier (K1) est détecté de manière univoque et annoncé conjointement avec le réseau (NW3) du point de contact particulier (7) auquel un court-circuit a été détecté au cours du contrôle principal, lorsque le réseau (NW3) spécifiquement non encore chargé au cours du test ultérieur a été chargé au potentiel de charge par le court-circuit particulier (K1) et en ce que, dans chaque cas, une erreur de test apparue au cours du contrôle principal est détectée lorsque le court-circuit particulier qui a été détecté à une cinquième étape du contrôle principal n'est pas confirmé.

4. Procédé selon la revendication 3, caractérisé en ce que les plusieurs réseaux sont réunis en au moins un groupe d'essai (TG1, TG2, TG3) et en ce que le contrôle principal est exécuté dans chaque cas pour un groupe d'essai (TG1) et complété par un test intermédiaire particulier, des réseaux (NW1) déjà redéchargés en raison d'un défaut et situés à l'intérieur du groupe d'essai particulier (TG1) sont déterminés au cours du test intermédiaire par le fait que dans chaque cas le potentiel d'au moins un point de contact (2) d'un réseau particulier (NW1) est mesuré et une détection est faite pour savoir si le potentiel correspond au potentiel de charge, en ce que tous les points de contact (1...24) sont déchargés avant un test ultérieur, qu'en ce qu'à une première étape du test ultérieur, dans chaque cas un réseau (NW1) déterminé au cours du test intermédiaire est chargé spécifiquement au potentiel de charge, en ce qu'à une deuxième étape du test ultérieur, des potentiels d'autres réseaux (NW2,NW3) du groupe d'essai particulier (T1) sont mesurés dans chaque cas par au moins un point de contact (5, 7) et en ce qu'à une troisième étape du test ultérieur, un court-circuit (K2) est déterminé et un autre réseau particulier (NW2) participant au court-circuit (K2) est détecté de manière univoque et annoncé conjointement avec le réseau (NW1), qui a été chargé spécifiquement au cours de la première étape particulière du test ultérieur et qui participe également au court-circuit (K2), lorsque le réseau (NW1) spécifiquement non encore chargé au cours du test ultérieur avait été chargé au potentiel de charge par le court-circuit (K2).

5. Procédé selon la revendication 4, caractérisé en ce qu'à une première étape d'un test intermédiaire particulier, chacun des potentiels de réseaux (NW4..NW9) d'autres groupes d'essai (TG2, TG3) est mesuré par au moins un point de contact (10, 12, 15, 17, 20 et 22) du réseau particulier (NW4) de l'autre groupe d'essai (TG2), en ce qu'à une deuxième étape du test intermédiaire particulier, un court-circuit particulier (K3), qui chevauche des groupes d'essai et qui fait partie de l'un des réseaux (NW2) du groupe particulier d'essai (TG1) qui ont déjà été chargés spécifiquement au cours du contrôle principal particulier, avec un réseau particulier (NW4) de l'autre groupe d'essai (TG2) est détecté par le fait qu'au moins un point de contact (10) du réseau particulier (NW4) de l'autre groupe d'essai (TG2) a déjà été chargé au potentiel de charge par le court-circuit particulier (K3) qui chevauche des groupes d'essai.

6. Procédé selon la revendication 5, caractérisé en ce qu'une troisième étape d'un test intermédiaire particulier consiste à décharger tous les points de contact (1...24) de la carte de circuits imprimés (LP), en ce qu'à une première étape d'un test ultérieur, le réseau (NW4) du point de contact particulier (10) chevauchant des groupes d'essai et auquel un court-circuit chevauchant des groupes d'essai a été détecté au cours du test intermédiaire est chargé spécifiquement au potentiel de charge par un court-circuit particulier chevauchant des groupes d'essai, en ce qu'à une deuxième étape du test ultérieur, des potentiels de réseaux (NW1...NW3, NW7...NW9) d'un autre groupe particulier d'essai (TG1, TG3) qui n'ont spécifiquement pas encore été chargés au cours du test ultérieur sont déterminés par le fait que dans chaque cas le potentiel est mesuré par au moins un point de contact (2, 4, 7, 17, 20, 22) du réseau particulier (NW1...NW3, NW7...NW9) de l'autre groupe d'essai particulier (TG1, TG3) qui n'a spécifiquement pas encore été chargé au cours du test ultérieur, en ce qu'à une troisième étape du test ultérieur, un court-circuit particulier (K3) chevauchant des groupes d'essai et ayant été détecté à une deuxième étape du test intermédiaire est confirmé lorsqu'un réseau (NW2) de l'autre groupe d'essai particulier (TG1) qui n'a spécifiquement pas encore été chargé au cours du test ultérieur a été chargé au potentiel de charge par le court-circuit particulier (K3) chevauchant des groupes d'essai et en ce qu'une erreur de contrôle est détectée lorsque le court-circuit détecté à une troisième étape du contrôle principal n'est pas confirmé.
